# EUROPÄISCHE PATENTSCHRIFT

(11) **EP 2 665 184 B1**
(45) Veröffentlichungstag und Bekanntmachung des Hinweises auf die Patenterteilung: **02.09.2015**
(21) Anmeldenummer: 13164355.3
(22) Anmeldetag: 18.04.2013
(51) Int. Cl.: H03K 5/13, G02B 21/00

(54) **Schaltung und Verfahren zum Erzeugen von periodischen Steuersignalen sowie Mikroskop und Verfahren zum Steuern eines Mikroskops**
Circuit and method for generating periodic control signals for microscope and method for controlling a microscope
Circuit et procédé de génération de signaux de commande périodiques pour microscope et procédé de commande d'un microscope

(30) Priorität: 18.05.2012 DE 102012208379; 10.09.2012 DE 102012216002
(43) Veröffentlichungstag der Anmeldung: 20.11.2013
(73) Patentinhaber: Leica Microsystems CMS GmbH, 35578 Wetzlar (DE)
(72) Erfinder: Köster, Thorsten, 68535 Edingen-Neckarhausen (DE)
(74) Vertreter: Patent- und Rechtsanwälte Ullrich & Naumann

(56) Entgegenhaltungen:
- EP-A2- 0 363 931
- EP-A2- 0 363 931
- EP-A2- 0 618 678
- WO-A2-2006/023427
- GB-A- 2 475 768
- US-A1- 2009 066 390

## Beschreibung

Die Erfindung betrifft eine Schaltung zum Erzeugen von periodischen Steuersignalen, insbesondere für ein Mikroskop, wobei die Schaltung zum Erzeugen und Ausgeben mindestens zweier gegeneinander phasenverschobener Steuersignale ausgebildet ist, wobei die Schaltung mehrere Generatorschaltungen aufweist, wobei für die Erzeugung eines jeden durch die Schaltung ausgegebenen Steuersignals eine separate Generatorschaltung ausgebildet ist, wobei jede Generatorschaltung einen Phasenwertspeicher zur Speicherung eines Phasenwertes aufweist, wobei der Phasenwert eine Phasenverschiebung definiert, wobei jede Generatorschaltung einen Aktivierungseingang aufweist, wobei die Generatorschaltung bei Anliegen eines Aktivierungspegels am Aktivierungseingang die Erzeugung eines Steuersignal startet, das um die durch den Phasenwert definierte Phasenverschiebung verschoben ist, wobei die Generatorschaltungen gemeinsam durch ein Taktsignal getaktet sind, wobei die ausgegebenen Steuersignale periodische Pulsfolgen sind und wobei jede Generatorschaltung einen Zähler aufweist, dessen Zählerstand sich bei einer Flanke des Taktsignals ändert.

Die Erfindung betrifft ferner ein entsprechendes Verfahren zum Erzeugen von mehreren periodischen Steuersignalen unter Verwendung einer Schaltung mit mehreren Generatorschaltungen, die jeweils eines der Steuersignale erzeugen und ausgeben und gemeinsam durch ein Taktsignal getaktet sind, wobei der Zählerstand eines jeden Zählers bei einer Flanke des Taktsignals geändert wird.

Des Weiteren betrifft die Erfindung ein Mikroskop mit mehreren elektrisch und/oder elektronisch steuerbaren Komponenten sowie ein Verfahren zum Steuern eines Mikroskops.

Gegeneinander phasenverschobene Steuersignale werden in der Technik vielfach benötigt. Bei der Erzeugung der periodischen, gegeneinander phasenverschobener Steuersignale ist es notwendig, dass die Phasenbeziehung zwischen den Steuersignalen wohl definiert ist. In der Praxis bedeutet dies meist, dass die Steuersignale synchron sein müssen, d.h. die Steuersignale weisen die gleiche Periodenlänge auf oder zumindest Periodenlängen, die ein ganzzahliges Vielfaches voneinander sind.

Ein Anwendungsbereich, bei dem Steuersignale mit großer Genauigkeit notwendig sind, sind Mikroskope, insbesondere Konfokalmikroskope, beispielsweise STED-und FLIM-Mikroskope. Dort werden zwei oder mehr phasenverschobene, synchrone Steuersignale benötigt, um die Beleuchtungslaser und gegebenenfalls die Detektionseinrichtung zu steuern.

STED (Stimulated Emission Depletion)-Mikroskope erlauben Auflösungen, die über die theoretisch mögliche Grenze von optischen Mikroskopen hinausgehen, d.h. es können Strukturen aufgelöst werden, die kleiner als λ/2 des Beleuchtungslichts sind. Dabei wird der Effekt ausgenutzt, dass eine fluoreszierende Probe bei Beleuchtung mit einer Wellenlänge nahe der Fluoreszenzwellenlänge zu einem Übergang von einem angeregten Zustand in einen abgeregten Zustand veranlasst wird. Bei einem STED-Mikroskop wird eine fluoreszierende Probe zunächst mit einem kurzwelligen Laserstrahl angeregt und danach mit einem langwelligen Laserstrahl abgeregt, wobei der langwellige Laserstrahl eine ringförmige Intensitätsverteilung hat mit einer Intensität nahe Null im Zentrum. Auf diese Weise lassen sich Auflösungen bis zu 30 nm und weniger erreichen. Wesentlich für das Erzielen derart hoher Auflösungen ist eine möglichst genaue zeitliche Steuerung der Laser.

Entsprechendes gilt bei FLIM (Fluorescence Lifetime Imaging Microscopy)-Mikroskopen, bei denen die "Lebensdauer" eines angeregten Zustands eines Fluoreszenzmoleküls gemessen wird. Bei FLIM mit PIE (Pulse Interleaved Excitation) wird die Probe abwechselnd mit Lasern unterschiedlicher Wellenlänge angeregt. Auch dort müssen Laser mit einer wohl definierten zeitlichen Beziehung zueinander gesteuert werden.

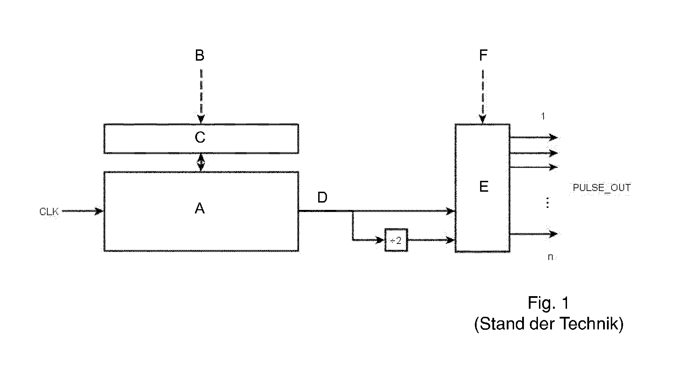

Zum Erzeugen derartiger Steuersignale ist aus dem Stand der Technik eine Schaltung bekannt, wie sie in Fig. 1 schematisch dargestellt ist. Ein Taktsignal CLK wird auf einen Pulsgenerator A gegeben, der häufig als Aufwärtszähler ausgestaltet ist. Bei Erreichen eines Vergleichswerts B, der in einem Register C gespeichert ist, wird am Ausgang D des Pulsgenerators A ein Puls mit der Breite eines aktiven Pegels des Taktsignals CLK ausgegeben und der Zähler zurückgesetzt. Die an Ausgang D ausgegebene Pulsfolge und eine mittels eines Taktteilers aus dieser Pulsfolge erzeugtes weiteres Signal werden an eine Schaltung E gegeben, die die Steuersignale erzeugt und ausgibt. Die Schaltung E wird im Wesentlichen durch einen Multiplexer und eine Schaltlogik gebildet, wobei die Schaltung E in gewissen Grenzen durch eine Konfiguration F eingestellt werden kann. Je nach Konfiguration F wird an den Ausgängen der Schaltung E Steuersignale PULSE_OUT1 bis n ausgegeben. Meist werden lediglich an zwei der Ausgänge gegeneinander phasenverschobene Signale benötigt.

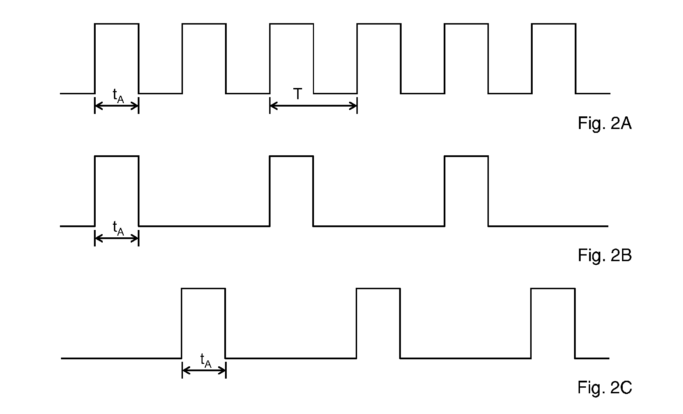

Fig. 2 zeigt zur bessern Erkennbarkeit des zugrundeliegenden Prinzips ein stark vereinfachtes Beispiel verschiedener Pulsfolgen. In Fig. 2A ist eine Pulsfolge dargestellt, wie sie durch Pulsgenerator A an Ausgang D ausgegeben wird. Der Einfachheit wegen ist die Pulsfolge identisch zu dem anliegenden Taktsignals CLK angenommen. Dies kann dadurch erreicht werden, dass in Register C ein Vergleichswert gleich 1 abgelegt ist. Dadurch erreicht der Zähler bei jeder steigenden Taktflanke den Vergleichswert und es wird eine Pulsgenerierung und ein Zurücksetzen des Zählers veranlasst Die Pulsfolge hat eine Periodenlänge T; jeder aktive Pegel der Pulsfolge hat eine Breite t_{A}.

Die Schaltung E erzeugt aus dieser Pulsfolge die in Fig. 2B und 2C dargestellten Pulsfolgen, wobei die in Fig. 2C dargestellte Pulsfolge um 180° phasenverschoben zu der Pulsfolge nach Fig. 2B ist.

Nachteilig bei der aus dem Stand der Technik bekannten Schaltung ist deren geringe Flexibilität. Durch Definition der Schaltung E sind - abgesehen von den geringfügigen Konfigurationsmöglichkeiten - die Ausgabesignale der Schaltung festgelegt. Andere als die derart festgelegten Ausgabesignale können nicht erzeugt werden. Für jede über die Konfigurationsmöglichkeiten hinausgehende Änderung muss die Schaltung E grundlegend überarbeitet werden.

Die WO 2006/023427 offenbart eine Schaltung zum Erzeugen von pulsweitenmodulierten Signalen (PWM-Signalen), wobei die Schaltung zum Erzeugen und Ausgeben vierer gegeneinander phasenverschobener PWM-Signale ausgebildet ist. Ein Master-Timer-Block gibt periodisch einen Puls an mehrere PWM-Channel-Timer aus. Der Puls veranlasst die einzelnen PWM-Channel-Timer dazu, den Inhalt aus einem Offset-Register in einen Zähler zu laden und aufwärts zu zählen. Sobald ein PWM-Channel-Timer einen in einem Periodenregister gespeicherten Wert annimmt, wird dieser PWM-Channel-Timer auf Null gesetzt und beginnt erneut zu zählen. Aus dem Ausgangssignal des PWM-Channel-Timers wird mittels eines Komparators ein PWM-Signal erzeugt.

Die US 2009/0066390 A1 offenbart eine Timingschaltung zum Ansteuern von Pipeline-Registern eines SDRAM genutzt werden. Aus einem Grundtakt werden mittels Verzögerungsschaltungen verzögerte Taktsignale erzeugt, die als Steuersignale in eine Speicherarray-Steuerschaltung gegeben werden. Jede Verzögerungsschaltung ist mit einer Befehlsdekodierschaltung verbunden, die einen Aktivierungsbefehl an die einzelnen Generatorschaltungen ausgibt. Dabei ist das Triggern der Verzögerungsschaltungen ausschließlich der Befehlsdekodierschaltung überlassen, was in vielen Anwendungen zu unflexibel ist.

Aus der US 6,905,571 B1 ist eine zählerbasierte Taktgeneratorschaltung bekannt, bei der mittels einer Kaskade von Zählern und Flipflops zusammen mit einem Addierer vier gegeneinander phasenverschobene Taktsignale erzeugt werden. Die Schaltung enthält Register, in denen Zählerstände eingeladen und für Vergleiche herangezogen werden. Die relative Phasenlage wird durch die Schaltung bzw. die verwendeten Bits der Register bestimmt.

Der vorliegenden Erfindung liegt daher die Aufgabe zugrunde, eine Schaltung und ein Verfahren der eingangs genannten Art derart auszugestalten und weiterzubilden, dass flexibel mindestens zwei gegeneinander phasenverschobene Steuersignale erzeugbar sind. Ein entsprechendes Verfahren soll angegeben werden. Des Weiteren soll ein Mikroskop und ein Verfahren zum Steuern eines Mikroskops angegeben werden, bei dem eine flexible Einstellung des gegeneinander phasenverschobenen Steuersignale möglich ist.

Erfindungsgemäß wird die voranstehende Aufgabe durch die Merkmale des Anspruchs 1 gelöst. Danach ist die Schaltung gemäss dem Oberbegriff um Anspruch 1 dadurch gekennzeichnet, dass die Aktivierungseingänge der Generatorschaltungen gemeinsam mit einer Aktivierungsschaltung zur gleichzeitigen Ausgabe eines Aktivierungspegels an die Generatorschaltungen verbunden sind, dass der Zähler jeder Generatorschaltung bei Erreichen eines vorgebbaren Zählerstandes einen Puls ausgibt und dass bei Anliegen eines Aktivierungspegels an dem Aktivierungseingang der Phasenwert aus dem Phasenwertspeicher in den Zähler geladen wird.

In verfahrensmäßiger Hinsicht ist die voranstehende Aufgabe durch die Merkmale des Anspruchs 7 gelöst. Danach ist die Verfahren gemäss dem Oberbegriff um Anspruch 7 gekennzeichnet durch die Schritte: Erzeugen eines Aktivierungspegels durch eine Aktivierungsschaltung, Anlegen eines Aktivierungspegels an Aktivierungseingängen der Generatorschaltungen zum Aktivieren der Generatorschaltungen, Laden eines Phasenwertes aus einem Phasenwertspeicher in einen Zähler jeder Generatorschaltung als deren Startwert, wobei jede Generatorschaltung (1) einen Phasenwertspeicher (4) aufweist, und Erzeugen eines Steuersignals als periodische Pulsfolge, das um eine durch den Phasenwert definierte Phasenverschiebung verschoben ist, bei Erreichen eines vorgebbaren Zählerstandes.

Hinsichtlich eines Mikroskops ist die zuvor aufgezeigte Aufgabe durch die Merkmale des Anspruchs 9 gelöst. Danach ist ein Mikroskop angegeben, wobei das Mikroskop eine Schaltung zum Erzeugen von periodischen Steuersignalen umfasst, wobei die Steuersignale gegeneinander phasenverschoben sind, wobei die Steuersignale dem Steuern der Komponenten dienen und wobei die Schaltung zum Erzeugen der periodischen Steuersignale durch eine Schaltung nach einem der Ansprüche 1 bis 6 gebildet ist.

Hinsichtlich eines Verfahrens zum Steuern eines Mikroskops ist die voranstehende Aufgabe durch die Merkmale des Anspruchs 11 gelöst. Danach ist ein Verfahren zum Steuern eines Mikroskops mit mehreren elektrisch und/oder elektronisch steuerbaren Komponenten unter Verwendung von periodischen Steuersignalen, beansprucht, wobei die periodischen Steuersignale unter Verwendung eines Verfahrens nach einem der Ansprüche 7 oder 8 erzeugt werden

In erfindungsgemäßer Weise ist zunächst erkannt worden, dass es für das Erzielen einer definierten Phasenbeziehung zwischen den einzelnen ausgegebenen Steuersignalen nicht zwangsläufig notwendig ist, dass die einzelnen Steuersignale durch ein gemeinsames Schaltwerk erzeugt werden. Erfindungsgemäß weist die Schaltung vielmehr mehrere separate Generatorschaltungen auf, die jeweils eines der gegeneinander phasenverschobenen Steuersignale erzeugen. Dabei können die Generatorschaltungen unabhängig voneinander ausgestaltet sein, sodass eine wesentlich freiere Konfigurierbarkeit erreichbar ist.

Zum Definieren der Phasenlage der einzelnen Steuersignale weist jede Generatorschaltung einen Phasenwertspeicher auf, der einen Phasenwert speichert. Dieser Phasenwert definiert eine Phasenverschiebung des durch die jeweilige Generatorschaltung erzeugten Steuersignals. Durch die Verwendung eines Phasenwertspeichers für jede Generatorschaltung kann eine Phasenverschiebung relativ zu einem gemeinsamen Zeitpunkt über alle Generatorschaltungen definiert werden. Zwar kann prinzipiell bei einer der Generatorschaltungen auf den Phasenwertspeicher verzichtet und diese Generatorschaltung als "Referenz" verwendet werden, allerdings reduziert sich dadurch die Flexibilität der Schaltung.

Jede Generatorschaltung weist ferner einen Aktivierungseingang auf, über den die Generatorschaltung in einen definierten Grundzustand versetzt werden kann. Bei Anliegen eines Aktivierungspegels am Aktivierungseingang startet die jeweilige Generatorschaltung die Erzeugung eines Steuersignals, das um die durch den Phasenwert definierte Phasenverschiebung verschoben ist. Damit wird unabhängig von dem Zustand einer Generatorschaltung vor dem Anliegen des Aktivierungssignals ein definiertes Ausgangssignal mit definierter Phasenlage erzeugt.

Ein Aktivierungspegel am Aktivierungseingang kann die Generatorschaltung aktivieren und dadurch erst eine Ausgabe eines Steuersignals starten. Alternativ kann die Generatorschaltung bereits ein Steuersignal ausgeben. Das Anliegen eines Aktivierungspegels am Aktivierungseingang sorgt dann dafür, dass die Generatorschaltung in einen definierten Grundzustand (zurück-)versetzt wird. Dies kann beispielsweise zum nochmaligen Synchronisieren bereits laufender Generatorschaltungen genutzt werden.

Es sei darauf hingewiesen, dass der Aktivierungspegel nicht dauerhaft an dem Aktivierungseingang anliegen muss. Vielmehr ist es ausreichend, wenn der Aktivierungspegel zu einem definierten Ereignis anliegt, beispielsweise einer steigenden Taktflanke. Prinzipiell könnte auch eine steigende Flanke am Aktivierungseingang für das (Zurück-)Versetzen der Generatorschaltung in einen Grundzustand genutzt werden.

Erfindungsgemäß sind ferner die Aktivierungseingänge der einzelnen Generatorschaltungen mit einer Aktivierungsschaltung verbunden. Die Aktivierungsschaltung gibt gleichzeitig einen Aktivierungspegel an die Generatorschaltungen aus, wodurch die Generatorschaltungen gleichzeitig mit der Erzeugung der Steuersignale beginnen. Durch diese Maßnahmen werden durch die Generatorschaltungen Steuersignale mit einer definierten relativen Phasenlage erzeugt und ausgeben. Gleichzeitig entsteht eine Schaltung, die äußerst flexibel eingestellt und genutzt werden kann. Insbesondere ist die Schaltung nahezu beliebig skalierbar. Durch Ergänzung der Schaltung um eine weitere Generatorschaltung kann ein weiteres Steuersignal erzeugt werden. Da auch die weitere Generatorschaltung mit der Aktivierungsschaltung verbunden ist und damit gleichzeitig mit allen Generatorschaltungen einen Aktivierungspegel erhält, ist das weitere Steuersignal ohne zusätzliche Maßnahmen synchron. Auf diese Weise ist eine hochgradig skalierbare Gesamtschaltung erreicht.

Zur noch weiteren Verbesserung der Synchronität der einzelnen Steuersignale werden die Generatorschaltungen durch ein gemeinsames Taktsignal getaktet. Auf diese Weise erzeugen die Generatorschaltungen stets auf definierte Art und Weise Steuersignale, die nicht nur gemeinsam starten sondern auch auf einen gemeinsamen Grundtakt beruhen. Wenn zusätzlich die einzelnen Generatorschaltungen identisch aufgebaut sind, kann das Verhalten der Gesamtschaltung noch weiter verbessert werden. Vorzugsweise ist das Taktsignal ein periodisches Rechtecksignal.

Als Steuersignale lassen sich prinzipiell verschiedenste periodische Signalfolgen erzeugen. Ausschlaggebend ist lediglich, dass eine definierte Phasenlage erzeugbar ist. In einer bevorzugten Ausgestaltung der Schaltung sind die ausgegebenen Steuersignale jedoch periodische Pulsfolgen. Dabei weist jeder Puls der Pulsfolge vorzugsweise eine Breite eines aktiven Pegels des Taktsignals auf. Dabei kann während der verbleibenden Periodendauer das Steuersignal einen Low-Pegel annehmen.

Prinzipiell lassen sich durch die erfindungsgemäße Schaltung Steuersignale mit den verschiedensten Periodenlängen erzeugen. Dabei können auch bei der Ausgabe von mehreren Steuersignalen Steuersignale mit unterschiedlichen Periodenlängen erzeugt werden. Durch die modulare Ausgestaltung der erfindungsgemäßen Schaltung können die Periodenlängen für jede Generatorschaltung separat gesteuert werden. Vorzugsweise werden durch die erfindungsgemäße Schaltung jedoch Steuersignale ausgegeben, die gleiche Periodenlänge aufweisen oder bei denen die Periodenlängen ganzzahlige Vielfach voneinander sind.

Erfindungsgemäß weisen die Generatorschaltungen einen Zähler auf, dessen Zählerstand sich bei einer Flanke des Taktsignals ändert und der bei Erreichen eines vorgebbaren Zählerstands einen Puls ausgibt. Dabei können Aufwärtszähler ebenso eingesetzt werden wie Abwärtszähler. Auch können die Zähler auf steigende und/oder fallende Flanken mit einer Änderung des Zählerstandes reagieren.

Bevorzugter Weise kommt jedoch ein Abwärtszähler zum Einsatz, dessen Zählerstand bei jeder steigenden Flanke des Taktsignals dekrementiert wird. Als "vorgebbarer Zählerstand" wird dann ein Zählerstand von 0 verwendet. Durch diese Ausgestaltung lässt sich die Generatorschaltung besonders einfach und mit geringem schaltungstechnischem Aufwand aufbauen.

Bei Ausgestaltung der Generatorschaltungen mit einem Abwärtszähler kann die Generatorschaltung zusätzlich einen Startwertspeicher aufweisen, in dem ein Startwert gespeichert ist. Im Betrieb würde der Zähler beispielsweise mit jeder steigenden Flanke des Taktsignals dekrementiert und bei Erreichen eines Zählerstandes von 0 würde der Startwert aus dem Startwertspeicher geladen. Bei der nächsten steigenden Flanke des Taktsignals würde ausgehend von dem Startwert der Zählerstand weiter dekrementiert. Auf diese Weise lassen sich Pulsfolgen mit konstanter Periodenlänge erzeugen.

Zur Festlegung einer definierten Phasenlage der einzelnen Steuersignale sind die Generatorschaltungen derart ausgebildet, dass bei Anliegen eines Aktivierungspegels an dem Aktivierungseingang der Phasenwert aus dem jeweiligen Phasenwertspeicher in den Zähler geladen wird. Auf diese Weise ist der Zähler in Abhängigkeit des Phasenwerts mehr oder weniger "nahe" an dem vorgebbaren Zählerstand, bei dem eine Pulsgenerierung ausgelöst wird. Dadurch kann auf einfache Art und Weise eine Phasenlage der einzelnen Steuersignale festgelegt werden.

In einer besonders einfachen Ausgestaltung der Aktivierungsschaltung könnte die Aktivierungsschaltung mittels einer ODER-Verknüpfung die Schreibzugriffe auf die Startwertspeicher und/oder Phasenwertspeicher der Generatorschaltungen auswerten. Auf diese Weise würde durch jede Veränderung eines Startwerts und/oder eines Phasenwerts die Generatorschaltungen zurückgesetzt und die einzelnen Generatorschaltungen entsprechend des gespeicherten Phasenwertes in einen definierten Grundzustand gebracht.

Zusätzlich oder alternativ kann die Aktivierungsschaltung externe Ereignisse auswerten und basierend hierauf die Aktivierungssignale an die Generatorschaltungen erzeugen. Hierzu können die verschiedensten wohldefinierten Ereignisse verwendet werden. Bei dem bevorzugten Einsatz der erfindungsgemäßen Schaltung bei einem Scanmikroskop können externe Ereignisse durch den Scanvorgang ausgelöst werden. Bei Scanmikroskopen werden Proben im Allgemeinen mäanderförmig durch einen Beleuchtungslaserstrahl abgetastet. Ein externes Ereignis, das die Ausgabe eines Aktivierungspegels auslösen kann, kann in dem Erreichen eines Umkehrpunkts beim Wechsel von einer Scanzeile in die nächste Scanzeile bestehen. Ein anderes externes Ereignis kann darin bestehen, dass der Scan eines Bildes abgeschlossen ist und der Beleuchtungslaser ein einen Anfangszustand zurückverfahren wird. Während des Zurückverfahrens können die Generatorschaltungen durch Erzeugen eines Aktivierungssignals zurückgesetzt werden.

Vorzugsweise kommt die erfindungsgemäße Schaltung im Zusammenhang mit einem Konfokalmikroskop zum Einsatz, insbesondere bei einem FLIM (Fluorescence Lifetime Imaging Microscopy)-Mikroskopen oder STED (Stimulated Emission Depletion)-Mikroskopen. Die Steuersignale steuern dabei die Laserstrahlen des Mikroskops. STED- und FLIM-Mikroskope sind speziell ausgebildete konfokale Mikroskope, bei denen eine zu untersuchende Probe mit einem Laserstrahl abgetastet wird. Die Steuersignale können aber auch zum Steuern von Peripherie Verwendung finden.

Vorzugsweise sind die Startwertspeicher und/oder die Phasenwertspeicher als Register ausgebildet. Auf diese Weise kann das Anliegen definierter Zahlen in den Speichern gewährleistet werden. Andererseits kann dann - bei entsprechendes Ausgestaltung der Aktivierungsschaltung - der für den Schreibzugriff notwendige Schreibpegel direkt durch die Aktivierungsschaltung ausgewertet werden und auf diese Weise ein eindeutiges Aktivierungssignal erzeugt werden.

Das erfindungsgemäße Mikroskop umfasst mehrere elektrisch und/oder elektronisch steuerbare Komponenten. Zur Steuerung der Komponenten kommt eine erfindungsgemäße Schaltung zum Einsatz, mit der periodische Steuersignale an die betreffenden Komponenten ausgebbar sind. Dabei kann durch die Schaltung die Phasenlage zwischen den einzelnen Steuersignalen eingestellt werden.

Die Komponenten des Mikroskops können durch eine Vielzahl von Komponenten gebildet sein. Sehr häufig werden die Komponenten eine oder mehrere Laserlichtquellen und gegebenenfalls eine Detektionseinrichtung umfassen. Die Komponenten können ferner Aktuatoren umfassen, die in oder bei dem Mikroskop vorgesehen sind. Diese Aktuatoren können beispielsweise zum Bewegen einer Scanvorrichtung des Mikroskops oder zum Bewegen der Probe, beispielsweise durch Bewegen des Probentisches, eingesetzt werden. Des Weiteren können die Komponenten Register oder Speicher umfassen, wobei durch ein Steuersignal der Schreib- oder Lesezugriff auf das Register oder den Speicher gesteuert wird. So kann ein Steuersignal beispielsweise das Laden eines Wertes in ein Register auslösen. Ein anderes Steuersignal kann den Zugriff auf einen Bildspeicher, beispielsweise der Detektionseinrichtung freigeben oder den Zugriff für eine Recheneinheit sperren. Andere Komponenten des Mikroskops können durch Recheneinheiten, insbesondere Mikroprozessoren, gebildet sein. Hierbei kann ein Steuersignal die Bearbeitung oder das Analysieren von Daten anstoßen oder eine Übermittlung von Daten an eine interne oder externe Anzeigevorrichtung auslösen. Wie die Auflistung bereits zeigt, können eine Vielzahl weitere, aus der Praxis bekannte Komponenten des Mikroskops gesteuert werden.

Es sei nochmal ausdrücklich darauf hingewiesen, dass es nicht zwangsläufig notwendig ist, dass jedes durch die Schaltung erzeugte Steuersignal eine identische und lediglich mit einer Phasenverschiebung verschobene Pulsfolge ist. Vielmehr lassen sich die Generatorschaltungen derart flexibel anpassen, dass die verschiedensten, untereinander synchronen Steuersignale ausgegeben werden. So können beispielweise bei der Verwendung eines FLIM-Mikroskops mit PIE ein Steuersignal zur Erzeugung eines Laserlichtstrahls mit einer ersten Wellenlänge, das zweite, dazu phasenverschobene Steuersignal zur Aktivierung eines zweiten Laserstrahls mit einer zweiten Wellenlänge verwendet werden. Ein drittes Steuersignal kann zur Weiterbewegung der Scanvorrichtung um einen Bildpunkt verwendet werden. Ein weiteres Steuersignal kann Schreibzugriffe auf einzelne Register der Schaltung aktivieren, während ein weiteres Steuersignal das Auslesen von Bildspeichern aus der Detektionseinrichtung steuert. Diese relativ einfache Aufzählung verdeutlicht sehr genau, wie flexibel die erfindungsgemäße Schaltung einsetzbar ist.

Es gibt nun verschiedene Möglichkeiten, die Lehre der vorliegenden Erfindung in vorteilhafter Weise auszugestalten und weiterzubilden. Dazu ist einerseits auf die dem Anspruch 1, 10 bzw. 13 nachgeordneten Ansprüche und andererseits auf die nachfolgende Erläuterung bevorzugter Ausführungsbeispiele der Erfindung anhand der Zeichnung zu verweisen. In Verbindung mit der Erläuterung der bevorzugten Ausführungsbeispiele der Erfindung anhand der Zeichnung werden auch im Allgemeinen bevorzugte Ausgestaltungen und Weiterbildungen der Lehre erläutert. In der Zeichnung zeigen
- Fig. 1: eine aus dem Stand der Technik bekannte Schaltung zum Erzeugen von Steuersignalen,
- Fig. 2: beispielhafte Verläufe für Steuersignale,
- Fig. 3: ein Ausführungsbeispiel einer Generatorschaltung für die Verwendung in einer erfindungsgemäßen Schaltung zum Erzeugen von Steuersignalen,
- Fig. 4: ein Ausführungsbeispiel einer erfindungsgemäßen Schaltung zum Erzeugen mehrerer Steuersignale unter Verwendung der Generatorschaltungen nach Fig. 3 und
- Fig. 5: ein Blockschaltbild eines erfindungsgemäßen Mikroskops unter Verwendung einer Schaltung nach Fig. 4.

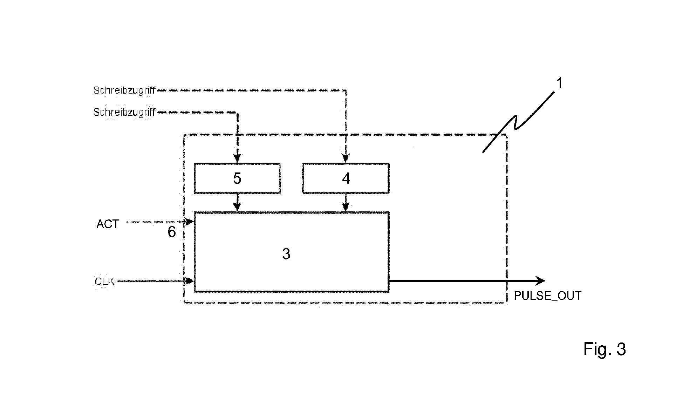

Fig. 3 zeigt ein Ausführungsbeispiel einer Generatorschaltung 1, die zum Erzeugen und Ausgeben eines Steuersignals ausgestaltet ist. Die Generatorschaltung 1 ist entsprechend der Anzahl der auszugebenden Steuersignale n-mal vorgesehen. Alle n Generatorschaltungen bilden gemeinsam die erfindungsgemäße Schaltung zum Erzeugen der Steuersignale.

Die Generatorschaltung 1 umfasst einen Zähler 3, der in dem vorliegenden Ausführungsbeispiel als Abwärtszähler ausgestaltet ist. Der Zähler 3 wird durch ein Taktsignal CLK getaktet, durch das der Zähler bei jeder steigenden Flanke des Taktsignals CLK dekrementiert wird, d.h. der Zählerstand wird bei jeder steigenden Flanke um 1 reduziert. Dem Zähler sind zwei Register zugeordnet, die als Phasenwertspeicher 4 und Startwertspeicher 5 genutzt werden. Im Phasenwertspeicher 4 ist ein Phasenwert gespeichert, der Startwertspeicher enthält einen Startwert.

Der Zähler enthält ferner einen Aktivierungseingang 6, über den ein Aktivierungssignal ACT auf den Zähler 3 geschaltet werden kann. Sobald an dem Aktivierungseingang 6 ein Aktivierungspegel anliegt, beginnt der Zähler 3. Hierzu wird zunächst aus dem Phasenwertspeicher 4 der Phasenwert als Zählerstand in den Zähler geladen. Mit der nächsten steigenden Taktflanke wird der Zählerstand dekrementiert. Sobald ein vorgebbarer Zählerstand - im vorliegenden Ausführungsbeispiel ein Zählerstand von 0 - erreicht ist, erzeugt der Zähler einen Puls, der als Steuersignal PULSE_OUT ausgegeben wird. Der ausgegebene Puls hat die Breite eines aktiven Pegels des Taktsignals. In Figur 2A ist die Breite des aktiven Pegels des Taktsignals mit t_{A} dargestellt. Zusätzlich zu der Erzeugung eines Pulses wird der im Startwertspeicher 5 abgelegte Startwert als neuer Zählerstand in den Zähler 3 geladen und danach bei der nächsten steigenden Flanke der Zählerstand erneut dekrementiert. Auf diese Weise entsteht eine Pulsfolge, deren Periodenlänge T über den Startwert im Startwertspeicher 5 gesteuert werden kann und dessen Phasenlage über den Phasenwert im Phasenwertspeicher beeinflussbar ist.

Die Auflösung der Generatorschaltung hängt im Wesentlichen von der Frequenz des Taktsignals CLK und der Breite des Zählers, des Phasenwertspeichers und des Startwertspeichers ab. Je größer deren Bitbreite desto mehr steigende Flanken des Taktsignals können gezählt werden.

Wie gut zu erkennen ist, kann das Taktsignal CLK im Wesentlichen durchlaufen, sodass keine zusätzlichen Schaltmittel für das Aktivieren und Deaktivieren des Taktes vorgesehen sein müssen. Über das Aktivierungssignal ACT wird der Zähler 3 gesteuert und die einzelnen Generatorschaltungen 1 untereinander synchronisiert. Weitere Mittel, die die Schaltung verkomplizieren, sind nicht notwendig.

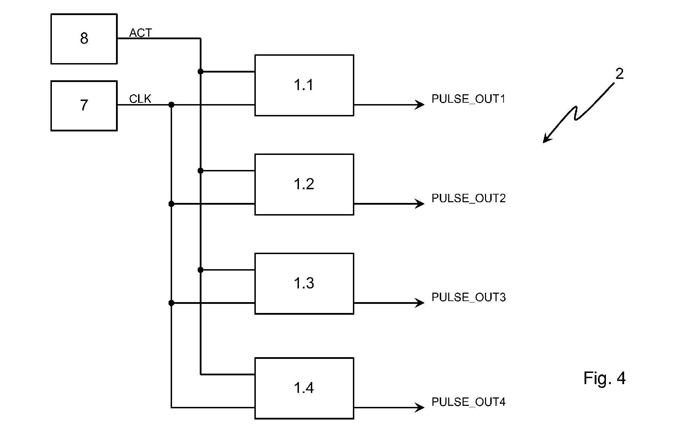

Fig. 4 zeigt beispielhaft eine Schaltung 2, zur Erzeugung von 4 Steuersignal PULSE_OUT1 bis PULSE_OUT4. Hierzu sind 4 Generatorschaltungen, nämlich 1.1, 1.2, 1.3 und 1.4 vorgesehen, die jeweils eines der Steuersignale PULSE_OUT1 bis PULSE_OUT4 erzeugen und ausgeben. Die Generatorschaltungen 1.1, 1.2, 1.3 und 1.4 sind entsprechend Figur 3 ausgestaltet.

Die Generatorschaltungen 1.1, 1.2, 1.3 und 1.4 sind durch ein gemeinsames Taktsignal CLK getaktet, das von einem Taktgenerator 7 erzeugt wird. Es sollte klar sein, dass der Taktgenerator nicht zwangsläufig lediglich zur Versorgung der Generatorschaltungen vorgesehen sein muss. Vielmehr können durch den Taktgenerator weitere Schaltungsteile oder Schaltungen versorgt werden oder es kann der Taktgenerator von anderen Komponenten eines größeren Systems verwendet werden.

Zur Erzeugung des Aktivierungssignals ACT umfasst die Schaltung 2 eine Aktivierungsschaltung 8, die eine gleichzeitige Erzeugung eines Aktivierungspegels an alle Generatorschaltungen 1 der erfindungsgemäßen Schaltung 2 erzeugt. In Fig. 4 ist dies durch eine gemeinsame Leitung an alle Generatorschaltungen 1 symbolisiert. Die Aktivierungsschaltung kann jedoch auch für jede Generatorschaltung eine eigene Treiberstufe enthalten, so dass jede Generatorschaltung mit einer separaten Leitung angesteuert wird. Die einzelnen Treiberstufen würden dennoch gemeinsam einen Aktivierungspegel erhalten.

Mit der Aktivierungsschaltung 8 werden die einzelnen Generatorschaltungen 1 untereinander synchronisiert. In einem bevorzugten Ausführungsbeispiel wertet die Aktivierungsschaltung 8 die Schreibzugriffe auf die Phasenwertspeicher 4 und/oder die Startwertspeicher 5 der Generatorschaltungen 1 aus. Bei dem in Fig. 4 dargestellten Beispiel würden acht Logikpegel mit einem logischen ODER verknüpft. Sobald ein Schreibzugriff auf eines der Register stattfindet, wird ein Aktivierungspegel erzeugt und die Generatorschaltungen in einen Ausgangszustand zurückversetzt.

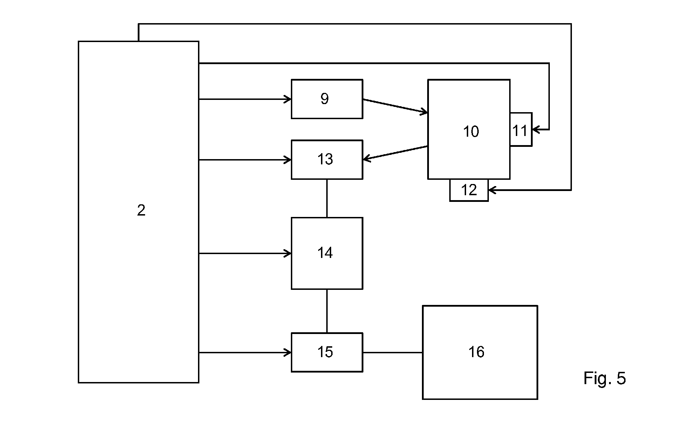

Fig. 5 zeigt ein Blockschaltbild eines erfindungsgemäßen Mikroskops unter Verwendung einer erfindungsgemäßen Schaltung nach Fig. 4. Die Schaltung 2 erzeugt sechs verschiedene Steuersignale, die allesamt entsprechend dem zuvor beschriebenen Verfahren in Periodenlänge und Phasenlage anpassbar sind. Die Steuersignale steuern Komponenten des erfindungsgemäßen Mikroskops, die in dem beschriebenen Ausführungsbeispiel durch eine Laserlichtquelle 9, Aktuatoren 11 und 12 zum Bewegen der Probe, einer Detektionseinrichtung 13, einem Bildspeicher 14 und einer Steuerrichtung 15 für eine externe Anzeigeeinrichtung 16 umfassen.

Beim Betrieb des Mikroskops steuert ein durch die Schaltung 2 ausgegebenes Steuersignal die Laserlichtquelle 9. Die Steuerung umfasst insbesondere das Verändern der Intensität. Die Laserlichtquelle erzeugt einen Beleuchtungslichtstrahl, der eine Probe 10 scannt. Die Probe kann durch Aktuatoren 11 und 12 in x- und y-Richtung verschoben werden. Hierzu werden Steuersignale durch die Schaltung 2 erzeugt, die in einer festen Phasenbeziehung zu dem Steuersignal zum Steuern der Laserlichtquelle stehen. Das von der Probe kommende Detektionslicht, das durch Reflektion des Beleuchtungslichtstrahl oder durch Fluoreszenz der Probe entsteht, gelangt durch eine Detektionseinrichtung 13, die in Abhängigkeit der Laserlichtquelle gesteuert wird. Die durch die Detektionseinrichtung 13 gewonnenen Bildinformationen werden in einem Bildspeicher abgelegt, deren Zugriff durch ein weiteres durch die Schaltung 2 erzeigtes Steuersignal gesteuert wird. Die in dem Bildspeicher abgelegten Bildinformationen können durch eine Steuereinrichtung 15 für eine Anzeigeeinrichtung 16 ausgelesen und geeignet für die Anzeige aufbereitet werden. Die Verarbeitung wird durch ein weiteres durch die Schaltung erzeugtes Steuersignal gesteuert.

Hinsichtlich weiterer vorteilhafter Ausgestaltungen der erfindungsgemäßen Schaltung bzw. des erfindungsgemäßen Verfahrens wird zur Vermeidung von Wiederholungen auf den allgemeinen Teil der Beschreibung sowie auf die beigefügten Patentansprüche verwiesen.

Schließlich sei ausdrücklich darauf hingewiesen, dass die voranstehend beschriebenen Ausführungsbeispiele der erfindungsgemäßen Schaltung lediglich zur Erörterung der beanspruchten Lehre dienen, diese jedoch nicht auf die Ausführungsbeispiele einschränken.

### Bezugszeichenliste

- A: Pulsgenerator
- B: Vergleichswert
- C: Register (für Vergleichswert)
- D: Ausgang (des Pulsgenerators)
- E: Schaltung
- F: Konfiguration (für Schaltung F)

- CLK: Taktsignal
- PULSE_OUT: Steuersignal
- ACT: Aktivierungssignal

- 1: Generatorschaltung
- 2: Schaltung
- 3: Zähler
- 4: Phasenwertspeicher
- 5: Startwertspeicher
- 6: Aktivierungseingang
- 7: Taktgenerator
- 8: Aktivierungsschaltung
- 9: Laserlichtquelle
- 10: Probe
- 11: Aktuator zum Bewegen der Probe in x-Richtung
- 12: Aktuator zum Bewegen der Probe in y-Richtung
- 13: Detektionseinrichtung
- 14: Bildspeicher
- 15: Steuereinrichtung für Anzeige
- 16: externe Anzeigeeinrichtung

## Patentansprüche

1. Schaltung zum Erzeugen von periodischen Steuersignalen, insbesondere für ein Mikroskop, wobei die Schaltung zum Erzeugen und Ausgeben mindestens zweier gegeneinander phasenverschobener Steuersignale ausgebildet ist,
wobei die Schaltung (2) mehrere Generatorschaltungen (1) aufweist, wobei für die Erzeugung eines jeden durch die Schaltung (2) ausgegebenen Steuersignals (PULSE_OUT) eine separate Generatorschaltung (1) ausgebildet ist,
wobei jede Generatorschaltung (1) einen Phasenwertspeicher (4) zur Speicherung eines Phasenwertes aufweist, wobei der Phasenwert eine Phasenverschiebung definiert,
wobei jede Generatorschaltung (1) einen Aktivierungseingang (6) aufweist, wobei die Generatorschaltung (1) bei Anliegen eines Aktivierungspegels am Aktivierungseingang (6) die Erzeugung eines Steuersignal (PULSE_OUT) startet, das um die durch den Phasenwert definierte Phasenverschiebung verschoben ist,
wobei die Generatorschaltungen (1) gemeinsam durch ein Taktsignal (CLK) getaktet sind,
wobei die ausgegebenen Steuersignale (PULSE_OUT) periodische Pulsfolgen sind und
wobei jede Generatorschaltung (1) einen Zähler (3) aufweist, dessen Zählerstand sich bei einer Flanke des Taktsignals (CLK) ändert,
**dadurch gekennzeichnet, dass** die Aktivierungseingänge (6) der Generatorschaltungen (1) gemeinsam mit einer Aktivierungsschaltung (8) zur gleichzeitigen Ausgabe eines Aktivierungspegels an die Generatorschaltungen verbunden sind,
dass der Zähler (3) jeder Generatorschaltung (1) bei Erreichen eines vorgebbaren Zählerstandes einen Puls ausgibt und
dass bei Anliegen eines Aktivierungspegels an dem Aktivierungseingang (6) der Phasenwert aus dem Phasenwertspeicher (4) in den Zähler (3) geladen wird.

2. Schaltung nach Anspruch 1, **dadurch gekennzeichnet, dass** jeder Puls der Pulsfolge die Breite (t_{A}) eines aktiven Pegels des Taktsignals (CLK) aufweist.

3. Schaltung nach Anspruch 1 oder 2, **dadurch gekennzeichnet, dass** der Zähler (3) als Abwärtszähler ausgebildet ist, dessen Zählerstand bei jeder steigenden Flanke des Taktsignals (CLK) dekrementiert wird.

4. Schaltung nach einem der Ansprüche 1 bis 3, **dadurch gekennzeichnet, dass** jede Generatorschaltung (1) einen Startwertspeicher (5) zur Speicherung eines Startwertes aufweist, wobei der Zähler (3) bei Erreichen des vorgebbaren Zählerstandes mit dem Startwert geladen wird.

5. Schaltung nach einem der Ansprüche 1 bis 4, **dadurch gekennzeichnet, dass** die Aktivierungsschaltung (8) Schreibzugriffe auf die Startwertspeicher (5) und/oder Phasenwertspeicher (4) der Generatorschaltungen (1) auswertet, wobei jede Veränderung eines Startwertspeichers und/oder eines Phasenwertspeichers eine Änderung eines Logikpegels bewirkt, die mittels einer ODER-Verknüpfung verknüpft werden, wodurch bei einem Schreibzugriff auf einen der Startwertspeicher und/oder Phasenwertspeicher ein Aktivierungspegel erzeugt wird.

6. Schaltung nach einem der Ansprüche 1 bis 5, **dadurch gekennzeichnet, dass** die Schaltung Steuersignale für ein Konfokalmikroskop, insbesondere ein FLIM (Fluorescence Lifetime Imaging Microscopy)-Mikroskop oder ein STED (Stimulated Emission Depletion)-Mikroskop erzeugt, wobei durch die Steuersignale vorzugsweise Laserstrahlen des Mikroskops gesteuert werden.

7. Verfahren zum Erzeugen von mehreren periodischen Steuersignalen (PULSE_OUT) unter Verwendung einer Schaltung mit mehreren Generatorschaltungen (1), die jeweils eines der Steuersignale (PULSE_OUT) erzeugen und ausgeben und gemeinsam durch ein Taktsignal (CLK) getaktet sind, wobei der Zählerstand eines jeden Zählers bei einer Flanke des Taktsignals (CLK) geändert wird,
**gekennzeichnet durch** die Schritte:
Erzeugen eines Aktivierungspegels **durch** eine Aktivierungsschaltung,
Anlegen des Aktivierungspegels an Aktivierungseingängen (6) jeder Generatorschaltung (1) zum Aktivieren der Generatorschaltungen (1),
Laden eines Phasenwertes aus einem Phasenwertspeicher (4) in einen Zähler (3) jeder Generatorschaltung (1) als deren Startwert, wobei jede Generatorschaltung (1) einen Phasenwertspeicher (4) aufweist, und
Erzeugen eines Steuersignals (PULSE_OUT) als periodische Pulsfolge, das um eine **durch** den Phasenwert definierte Phasenverschiebung verschoben ist, bei Erreichen eines vorgebbaren Zählerstandes.

8. Verfahren nach Anspruch 7, **dadurch gekennzeichnet, dass** in dem Schritt des Erzeugens des Steuersignals der Zähler (3) mit jedem steigenden Pegel des Taktsignals (CLK) dekrementiert oder inkrementiert wird und dass bei Erreichen eines vorgebbaren Zählerstandes ein Puls erzeugt und als Steuersignal (PULSE_OUT) ausgegeben wird.

9. Mikroskop mit mehreren elektrisch und/oder elektronisch steuerbaren Komponenten, wobei das Mikroskop eine Schaltung (2) zum Erzeugen von periodischen Steuersignalen nach einem der Ansprüche 1 bis 6 umfasst, wobei die Steuersignale dem Steuern der Komponenten dienen.

10. Mikroskop nach Anspruch 9, **dadurch gekennzeichnet, dass** die Komponenten des Mikroskops eine Laserlichtquelle (9), ein Aktuator zum Bewegen eines Scanvorrichtung des Mikroskops, ein Detektionseinrichtung (13), ein Aktuator (11, 12) zum Bewegen der Probe (10), ein Register in einer Steuereinheit, ein Bildspeicher (14) einer Detektionseinrichtung, eine Steuereinheit zum Übermitteln von Daten und/oder eine Recheneinheit zum Analysieren von Daten umfasst.

11. Verfahren zum Steuern eines Mikroskops mit mehreren elektrisch und/oder elektronisch steuerbaren Komponenten unter Verwendung von periodischen Steuersignalen, wobei die periodischen Steuersignale unter Verwendung eines Verfahrens nach Anspruch 7 oder 8 erzeugt werden.

## Claims

1. A circuit for generating periodic control signals, in particular for a microscope, the circuit being embodied to generate and to output at least two mutually phase-shifted control signals,
the circuit (2) comprising multiple generator circuits (1), a separate generator circuit (1) being embodied for generating each of the control signals (PULSE_OUT) outputted by the circuit (2),
each generator circuit (1) comprising a phase value memory (4) for storing a phase value, the phase value defining a phase shift,
each generator circuit (1) comprising an activation input (6), the generator circuit (1) starting, upon application of an activation level at the activation input (6), the generation of a control signal (PULSE_OUT) that is shifted by the phase shift defined by the phase value,
the generator circuits (1) being collectively clocked by a clock signal (CLK),
the outputted control signals (PULSE_OUT) being periodic pulse sequences, and
each generator circuit (1) comprising a counter (3) whose counter status changes at an edge of the clock signal (CLK),
wherein the activation inputs (6) of the generator circuits (1) are collectively connected to an activation circuit (8) for simultaneous output of an activation level to the generator circuits;
the counter (3) of each generator circuit (1) outputs a pulse when a predefinable counter status is reached; and
upon application of an activation level at the activation input (6), the phase value is loaded from the phase value memory (4) into the counter (3).

2. The circuit according to Claim 1, wherein each pulse of the pulse sequence has the width (t_{A}) of an active level of the clock signal (CLK).

3. The circuit according to Claim 1 or 2, wherein the counter (3) is embodied as a decrementing counter whose counter status is decremented at each rising edge of the clock signal (CLK).

4. The circuit according to one of Claims 1 to 3, wherein each generator circuit comprises a starting value memory (5) for storing a starting value, the counter (3) being loaded with the starting value when the predefinable counter status is reached.

5. The circuit according to one of Claims 1 to 4, wherein the activation circuit (8) evaluates write accesses to the starting value memories (5) and/or phase value memories (4) of the generator circuits (1), each modification of a starting value memory and/or of a phase value memory producing a change in a logic level which are combined by means of an OR operation, thereby generating an activation level upon a write access to one of the starting value memories and/or phase value memories.

6. The circuit according to one of Claims 1 to 5, wherein the circuit generates control signals for a confocal microscope, in particular a fluorescence lifetime imaging microscopy (FLIM) microscope or a stimulated emission depletion (STED) microscope, laser beams of the microscope preferably being controlled by the control signals.

7. A method for generating multiple periodic control signals (PULSE_OUT) using a circuit having multiple generator circuits (1) that each generate and output one of the control signals (PULSE_OUT) and are collectively timed by a clock signal (CLK), the counter status of each counter being changed at an edge of the clock signal (CLK),
**characterized by** the steps of:
generating an activation level by means of an activation circuit;
applying the activation level to activation inputs (6) of each generator circuit (1) in order to activate the generator circuits (1);
loading a phase value from a phase value memory (4) into a counter (3) of each generator circuit (1) as its starting value, each generator circuit (1) comprising a phase value memory (4); and
generating a control signal (PULSE_OUT), as a periodic pulse sequence that is shifted by a phase shift defined by the phase value, when a predefinable counter status is reached.

8. The method according to Claim 7, wherein in the step of generating the control signal, the counter (3) is decremented or incremented with each rising level of the clock signal (CLK); and when a predefinable counter status is reached, a pulse is generated and is outputted as a control signal (PULSE_OUT).

9. A microscope having multiple electrically and/or electronically controllable components, the microscope encompassing a circuit (2) according to one of Claims 1 to 6 for generating periodic control signals, the control signals serving to control the components.

10. The microscope according to Claim 9, wherein the components of the microscope encompass a laser light source (9), an actuator for moving a scanning apparatus of the microscope, a detection device (13), an actuator (11, 12) for moving the sample (10), a register in a control unit, an image memory (14) of a detection device, a control unit for transmitting data, and/or a calculation unit for analyzing data.

11. A method for controlling a microscope having multiple electrically and/or electronically controllable components by the use of periodic control signals, the periodic control signals being generated by the use of a method according to Claim 7 or 8.

## Revendications

1. Circuit pour générer des signaux de commande périodiques, en particulier pour un microscope, dans lequel le circuit est réalisé pour générer et émettre au moins deux signaux de commande mutuellement déphasés,
dans lequel le circuit (2) présente plusieurs circuits de générateur (1), dans lequel, pour la génération de chacun des signaux de commande (PULSE_OUT) émis par le circuit (2), un circuit de générateur (1) séparé est réalisé,
dans lequel chaque circuit de générateur (1) présente une mémoire de valeur de phase (4) pour l'enregistrement d'une valeur de phase, dans lequel la valeur de phase définit un déphasage,
dans lequel chaque circuit de générateur (1) présente une entrée d'activation (6), dans lequel le circuit de générateur (1) lance la génération d'un signal de commande (PULSE_OUT) lors de l'application d'un niveau d'activation à l'entrée d'activation (6), lequel signal est décalé de l'ordre du déphasage défini par la valeur de phase,
dans lequel les circuits de générateur (1) sont cadencés ensemble grâce à un signal d'horloge (CLK),
dans lequel les signaux de commande (PULSE_OUT) émis sont des trains d'impulsions périodiques et dans lequel chaque circuit de générateur (1) présente un compteur (3) dont la position de compteur varie au niveau d'un flanc du signal d'horloge (CLK),
**caractérisé en ce que** les entrées d'activation (6) des circuits de générateur (1) sont reliées ensemble avec un circuit d'activation (8) pour la sortie simultanée d'un niveau d'activation à l'attention des circuits de générateur,
**en ce que** le compteur (3) de chaque circuit de générateur (1) émet une impulsion en atteignant une position de compteur prescrite et
**en ce que**, en cas d'application d'un niveau d'activation à l'entrée d'activation (6), la valeur de phase est chargée, à partir de la mémoire de valeur de phase (4), dans le compteur (3).

2. Circuit selon la revendication 1, **caractérisé en ce que** chaque impulsion du train d'impulsions présente la largeur (t_{A}) d'un niveau actif du signal d'horloge (CLK).

3. Circuit selon la revendication 1 ou 2, **caractérisé en ce que** le compteur (3) est réalisé en tant que compteur décrémenteur dont la position de compteur est décrémentée à chaque flanc montant du signal d'horloge (CLK).

4. Circuit selon l'une des revendications 1 à 3, **caractérisé en ce que** chaque circuit de générateur (1) présente une mémoire de valeur initiale pour enregistrer une valeur initiale (5), dans lequel on charge la valeur initiale dans le compteur (3) lors de l'atteinte de la position de compteur prescriptible.

5. Circuit selon l'une des revendications 1 à 4, **caractérisé en ce que** le circuit d'activation (8) évalue des accès en écriture aux mémoires de valeur initiale (5) et/ou aux mémoires de valeur de phase (4) des circuits de générateur (1), dans lequel chaque modification d'une mémoire de valeur initiale et/ou d'une mémoire de valeur de phase provoque une modification d'un niveau logique, lesquelles sont mises en relation au moyen d'une opération OU, moyennant quoi en cas d'un accès en écriture à l'une des mémoires de valeur initiale et/ou mémoires de valeur de phase, un niveau d'activation est généré.

6. Circuit selon l'une des revendications 1 à 5, **caractérisé en ce que** le circuit génère des signaux de commande pour un microscope confocal, en particulier un microscope FLIM (Fluorescence Lifetime Imaging Microscopy) ou un microscope STED (Stimulated Emission Depletion), dans lequel, grâce aux signaux de commande, on commande de préférence des faisceaux laser du microscope.

7. Procédé pour générer plusieurs signaux de commande périodiques (PULSE_OUT) en utilisant un circuit avec plusieurs circuits de générateur (1) qui génèrent et émettent respectivement l'un des signaux de commande (PULSE_OUT) et sont cadencés ensemble grâce à un signal d'horloge (CLK), dans lequel la position de compteur de chaque compteur est modifiée au niveau d'un flanc du signal d'horloge (CLK),
**caractérisé par** les étapes suivantes :
la génération d'un niveau d'activation grâce à un circuit d'activation,
l'application du niveau d'activation à des entrées d'activation (6) de chaque circuit de générateur (1) pour l'activation des circuits de générateur (1),
la charge d'une valeur de phase à partir d'une mémoire de valeur de phase (4) dans un compteur (3) de chaque circuit de générateur (1) en tant que valeur initiale de ceux-ci, dans lequel chaque circuit de générateur (1) présente une mémoire de valeur de phase (4), et
la génération d'un signal de commande (PULSE_OUT) en tant que train d'impulsions périodique, lequel est décalé de l'ordre d'un déphasage défini par la valeur de phase lors de l'atteinte d'une position de compteur prédéfinissable.

8. Procédé selon la revendication 7, **caractérisé en ce que**, lors de l'étape de génération du signal de commande, le compteur (3) est décrémenté ou incrémenté à chaque niveau en augmentation du signal d'horloge (CLK) et **en ce qu'**à l'atteinte d'une position de compteur prédéfinissable, une impulsion est générée et est émise en tant que signal de commande (PULSE_OUT).

9. Microscope avec plusieurs composants pouvant être commandés électriquement et/ou électroniquement, dans lequel le microscope comprend un circuit (2) pour la génération de signaux de commande périodiques selon l'une des revendications 1 à 6, dans lequel les signaux de commande servent à la commande des composants.

10. Microscope selon la revendication 9, **caractérisé en ce que** les composants du microscope comprennent une source de lumière laser (9), un actionneur pour déplacer un dispositif de balayage du microscope, un dispositif de détection (13), un actionneur (11, 12) pour déplacer l'échantillon (10), un registre dans une unité de commande, une mémoire d'image (14) d'un dispositif de détection, une unité de commande pour la transmission de données et/ou une unité de calcul pour analyser des données.

11. Procédé pour commander un microscope avec plusieurs composants pouvant être commandés électriquement et/ou électroniquement en utilisant des signaux de commande périodiques, dans lequel les signaux de commande périodiques sont générés en utilisant un procédé selon la revendication 7 ou 8.
